Europäisches Patentamt

European Patent Office

Office européen des brevets

(11) Numéro de publication: **0 021 307**
**A1**

# DEMANDE DE BREVET EUROPEEN

(21) Numéro de dépôt: **80103350.7**

(22) Date de dépôt: **16.06.80**

(51) Int. Cl.³: **H 01 L 35/30**

(30) Priorité: **19.06.79 FR 7915714**

(43) Date de publication de la demande: **07.01.81**
**Bulletin 81/1**

(84) Etats contractants désignés: **BE DE GB IT NL SE**

(71) Demandeur: **Moracchioli, Robert, F-38770 La Motte d'Aveillans (FR)**

(72) Inventeur: **Moracchioli, Robert, F-38770 La Motte d'Aveillans (FR)**

(74) Mandataire: **Casalonga, Alain et al, Bureau D.A. Casalonga Lilienstrasse 77, D-8000 München 80 (DE)**

(54) **Dispositif pour le transfert de chaleur entre au moins deux sources de chaleur de manière à les maintenir à des niveaux thermiques différents.**

(57) Dispositif pour le transfert de chaleur entre deux sources de chaleur de manière à les maintenir à des niveaux thermiques différents comprenant un module thermoélectrique (1) et au moins un échangeur qui comprend une platine reliée thermiquement à une face du module (1) et servant de support à celui-ci, une surface d'échange (6) en contact avec une des sources de chaleur et des conduits de transfert de chaleur (5) scellés à leurs extrémités et remplis d'un fluide caloporteur à deux états, lesdits conduits présentant une première portion (5c) reliée thermiquement à la platine (4) et une seconde portion (5d) associée thermiquement à ladite surface d'échange thermique (6) et ces deux portions étant disposées l'une par rapport à l'autre de telle sorte que le mouvement du liquide dans le conduit s'effectue naturellement par gravité entre les deux portions si bien que l'échange de chaleur entre la source associée et le module ne se produit que dans un seul sens.

1                                                   0021307

Dispositif pour le transfert de chaleur entre au moins deux sources de chaleur de manière à les maintenir à des niveaux thermiques différents.

La présente invention concerne un dispositif pour le transfert de
chaleur entre au moins deux sources de chaleur de manière à les maintenir à
des niveaux thermiques différents, par l'intermédiaire d'un module à effet
thermoélectrique.

Les modules à effet thermoélectrique ont la particularité de présenter une face froide et une face chaude lorsqu'ils sont traversés par un
courant électrique, la face froide du module prenant de la chaleur à une
source froide pour la transmettre à un niveau de température plus élevé à sa
face chaude qui est reliée à une source chaude. Ils fonctionnent dans ce cas
selon l'effet PELTIER. Mais, si le courant est arrêté et si les modules thermoélectriques sont soumis à un écart de température, ils génèrent du courant.
Ils fonctionnent dans ce cas en effet SEEBECK et l'écart de température entre
les sources de chaleur chaude et froide associées aux modules tend à diminuer.

Comme il est bien connu, l'efficacité des modules thermoélectriques transformant la chaleur en électricité et réciproquement dépend énormément des écarts de température qui s'établissent entre les faces chaude et
froide de ces modules. Cette efficacité dépend donc des échangeurs de chaleur que l'on associe thermiquement aux faces des modules.

Différents types d'échangeurs ont déjà été utilisés. On a déjà en
effet utilisé des échangeurs à gaz ou à liquide présentant des surfaces
d'échange thermiques ailetées. Cependant, pour que le rendement du module
thermoélectrique soit acceptable, il est nécessaire de recourir à des moyens
mécaniques qui font circuler le gaz ou le liquide.

La présente invention a notamment pour but de remédier aux inconvénients résultant d'une part de la reversibilité des modules thermoélectriques et d'autre part de supprimer tout élément mécanique consommant de l'énergie nécessaire pour améliorer le rendement des échangeurs actuellement
utilisés en association avec les modules thermoélectriques.

Le dispositif, conforme à la présente invention, pour le
transfert de chaleur entre au moins deux sources de chaleur de manière
à les maintenir a des niveaux thermiques différents, comprend au
moins un module thermoélectrique à deux faces, générant une face
froide et une face chaude lorsqu'il est traversé par un courant
électrique et dont chaque face est reliée thermiquement à au moins

2          0021307

un échangeur de chaleur présentant, de préférence, une grande surface d'échange thermique avec la source associée par rapport à celle du module thermoélectrique.

Conformément à la présente invention, au moins l'échangeur relié à une des faces du module comprend au moins un conduit de transfert de chaleur scellé à ses extrémités et rempli d'un fluide de transfert de chaleur ou caloporteur à deux états, susceptible de s'évaporer à la température de la face du module ou de la source associée et susceptible de se condenser à la température de la source associée ou de la face dudit module.

Conformément à la présente invention, ledit conduit de transfert de chaleur présente une première portion reliée thermiquement audit module thermoélectrique et une seconde portion reliée thermiquement à la source associée et séparée de la première portion, ces portions étant disposées l'une par rapport à l'autre de telle sorte que le mouvement du liquide dans le conduit s'effectue naturellement par gravité entre les deux portions du conduit si bien que l'échange de chaleur entre la source associée et le module ne se produit, de ce fait, que dans un seul sens.

Selon une première variante de réalisation du dispositif selon la présente invention, ladite première portion est disposée au-dessous de ladite seconde portion et, de ce fait, contient le liquide, la première portion étant reliée thermiquement à la face chaude du module thermoélectrique et jouant le rôle d'évaporateur et la seconde portion jouant le rôle de condenseur.

Selon une autre variante, ladite première portion est disposée au-dessus de ladite seconde portion qui contient alors le liquide, cette seconde portion jouant le rôle d'évaporateur et la première portion étant reliée thermiquement à la face froide du module thermoélectrique et jouant le rôle de condenseur.

Avec le dispositif conforme à la présente invention tel qu'il vient d'être décrit, il est possible d'établir un transfert de chaleur entre deux sources qui ne puisse se produire que dans un seul sens lorsque le module thermoélectrique est alimenté en courant électrique car, lorsque l'alimentation en courant électrique est arrêtée, le conduit de transfert de chaleur présente une très grande résistance thermique dans l'autre sens.

Conformément à la présente invention, le dispositif comprend une platine rigide servant de support au module thermoélec- trique et audit conduit de transfert de chaleur. Cette platine est associée thermiquement à une face du module thermoélectrique et l'assemblage entre la platine et le module et entre la platine et ladite première portion du conduit est, de préférence, très bon conducteur thermique.

Selon deux modes de réalisation possibles dudit assemblage, ladite première portion du conduit peut être intégrée à ladite platine ou être rapportée sur cette dernière.

Conformément à la présente invention, on peut associer à ladite seconde portion du conduit de transfert au moins une surface d'échange thermique de manière à améliorer l'échange thermique entre le conduit et la source associée.

Conformément à la présente invention, une surface d'échange thermique quelconque peut être reliée thermiquement à une autre platine servant également de support audit module thermoélectrique et associée thermiquement à l'autre face de ce module. On peut cependant relier également cette autre face du module thermoélectrique à au moins un conduit de transfert de chaleur tel qu'il a été défini plus haut par l'intermédiaire d'une platine servant de support au module et à ce conduit, conduit auquel on peut également associer une surface d'échange thermique.

Conformément à la présente invention, l'échangeur relié thermiquement à une des faces du module thermoélectrique ou les échangeurs reliés respectivement aux deux faces du module thermoélectrique peuvent comprendre une multiplicité de conduits, chaque conduit fonctionnant de manière indépendante les uns par rapport aux autres. La seconde portion desdits conduits peut être reliée à des surfaces d'échange thermique différentes ou, de préférence, à une même surface d'échange thermique.

Conformément à une variante de réalisation du dispositif selon la présente invention, une première platine est reliée thermiquement à une des faces du module thermoélectrique et une seconde platine est reliée thermiquement à l'autre face de ce module, ces platines servant de support audit module. Ce dispositif comprend en outre une multiplicité de conduits dont la première portion est reliée thermiquement à une desdites platines, qui s'étendent à partir de cette dernière platine de telle sorte que leur seconde portion soit associée à une surface d'échange thermique sensiblement cylindrique, l'autre platine étant reliée thermiquement à une surface d'échange

0021307

thermique se présentant sous la forme d'une cuvette et ces surfaces d'échange thermique étant emboîtées l'une dans l'autre et séparées par un isolant thermique de manière à constituer un récipient.

Ladite surface d'échange thermique reliée thermiquement à ladite multiplicité de conduits peut être disposée sur la face extérieure dudit cylindre, la seconde portion desdits conduits se trouvant au-dessus de leur première portion de telle sorte que l'intérieur du récipient forme une enceinte réfrigérée.

La surface d'échange thermique qui est reliée thermiquement à ladite multiplicité de conduits peut également être disposée sur la face intérieure dudit cylindre, la seconde portion desdits conduits se trouvant au-dessus de leur première portion de telle sorte que l'intérieur du récipient forme une enceinte chauffée.

Conformément à la présente invention, l'intérieur desdites portions dudit conduit de transfert de chaleur peut être tapissé d'une structure poreuse de manière à améliorer l'échange de chaleur entre la première portion et le module thermoélectrique et entre la seconde portion et la source associée.

La présente invention sera mieux comprise à l'étude de dispositifs pour le transfert de chaleur entre deux sources de chaleur de manière à les maintenir à des niveaux thermiques différents, conformes à la présente invention et décrits à titre d'exemples non limitatifs et illustrés par le dessin sur lequel :

    - la figure 1 représente en perspective un dispositif comprenant deux échangeurs de chaleur munis de conduits de transfert de chaleur associés à un module thermoélectrique, conforme à la présente invention ;

    - la figure 2 représente un panneau comprenant un dispositif de structure semblable à celle du dispositif selon la figure 1 ;

    - la figure 3 représente une coupe schématique du panneau représenté sur la figure 2 ;

    - la figure 4 représente schématiquement et en perspective une enceinte dont une paroi est réalisée à l'aide de plusieurs dispositifs conformes à la figure 1 ;

    - la figure 5 représente un récipient cylindrique dont l'intérieur est climatisé à l'aide d'un dispositif conforme à la présente invention ;

    et la figure 6 représente en coupe radiale VI-VI le récipient de la figure 5.

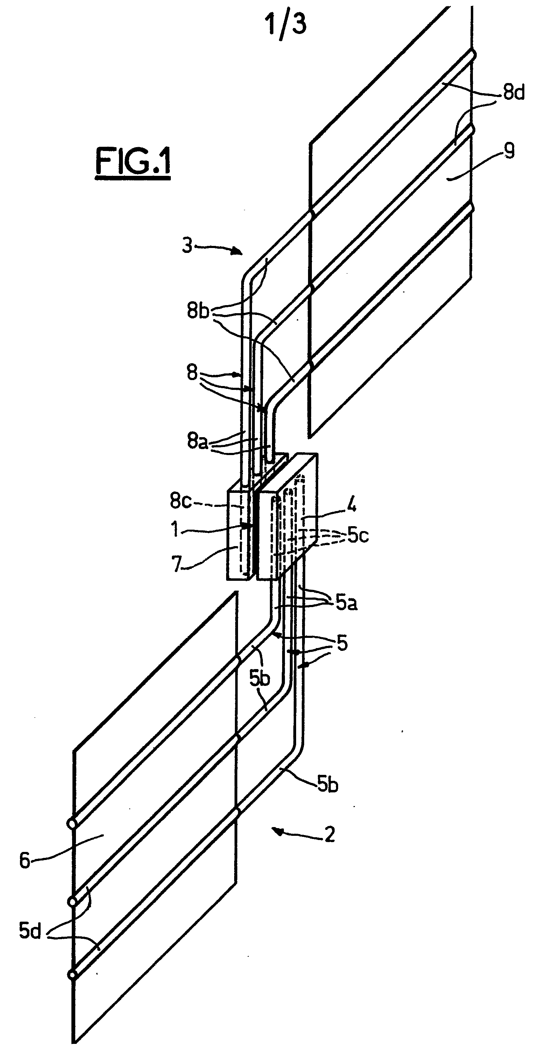

Le dispositif pour le transfert de chaleur entre deux sources de chaleur représenté sur la figure 1 comprend un module thermoélectrique 1 se présentant sous la forme d'une plaque disposée sensiblement verticalement. Ce module 1 peut être relié à une alimentation en courant non représentée. Lorsqu'il est traversé par un courant, le module thermoélectrique 1 génère une face froide et une face chaude de telle sorte qu'il prend de la chaleur par sa face froide pour l'évacuer par sa face chaude.

Le dispositif représenté sur la figure 1 comprend en outre un échangeur inférieur, repéré d'une manière générale par la référence 2, relié thermiquement à la face froide du module 1 et un échangeur supérieur, repéré d'une manière générale par la référence 3, relié thermiquement à la face chaude du module 1. L'échangeur 2 comprend une platine 4 associée thermiquement à la face froide du module 1, une multiplicité de conduits de transfert de chaleur 5, au nombre de trois dans l'exemple représenté, qui s'étendent vers le bas et une surface d'échange thermique 6 associée à une source froide non représentée sur la figure.

De manière symétrique, l'échangeur de chaleur 3 comprend une platine 7 associée thermiquement à la face chaude du module thermoélectrique 1, une multiplicité de conduits de transfert de chaleur 8, au nombre de trois dans l'exemple représenté, qui s'étendent vers le haut et une surface d'échange thermique 9 associée à une source chaude non représentée sur la figure.

Les platines 4 et 7 associées respectivement aux faces du module 1 se présentent sous la forme de plaques et sont rigides de manière à servir de support au module 1. Le module 1 est donc inséré entre les platines rigides 4 et 7.

Dans l'exemple représenté sur la figure 1, les conduits 5 sont coudés de manière à présenter une branche verticale 5a et une branche horizontale 5b et sont scellés à leurs extrémités.

La partie supérieure des branches verticales 5a forme une première portion 5c des conduits 5. Les premières portions 5c des conduits 5 sont reliées à la platine 4 en étant insérées dans celle-ci.

Sensiblement toute la longueur des branches horizontales 5b des conduits 5, à partir de leur extrémité, forme une seconde portion 5d des conduits 5. La seconde portion 5d de chaque conduit 5 est reliée thermiquement à la surface d'échange thermique 6 qui peut

0021307

être constituée par une plaque métallique mince par exemple soudée aux portions 5d des conduits 5 de manière à former des assemblages bons conducteurs de chaleur.

Dans l'exemple représenté, les conduits 5 sont superposés, se trouvent dans un même plan vertical et sont à distance les uns des autres. La surface d'échange thermique 6 est plane et se trouve dans le même plan vertical que les conduits 5.

Les conduits 5, qui sont scellés à leurs extrémités, sont remplis d'un fluide à l'état de vapeur et de liquide, liquide qui se dépose dans leur branche horizontale 5b.

De manière symétrique, les conduits 8 de l'échangeur 3 sont coudés de manière à présenter une branche verticale 8a et une branche horizontale 8b.

La partie inférieure d'extrémité des branches 8a des conduits 8 forme une première portion 8c qui est reliée thermiquement à la platine 7 en étant insérée dans celle-ci.

Sensiblement toute la longueur des branches horizontales 8b des conduits 8, à partir de leur extrémité, forme une seconde portion 8d des conduits 8 qui est reliée thermiquement à la surface d'échange thermique 9 constituée également par une plaque mince par exemple soudée aux portions 8d de manière à former des assemblages bons conducteurs thermiques.

De la même manière que pour l'échangeur 2, les conduits 8 sont superposés, se trouvent dans un même plan qui est parallèle au plan contenant les conduits 5 et sont à distance les uns des autres.

Les conduits 8 sont scellés à leurs extrémités et sont remplis d'un fluide à l'état de vapeur et de liquide, liquide qui se dépose à la partie inférieure des branches 8a dans les portions 8c.

On va maintenant décrire comment fonctionne le dispositif représenté sur la figure 1.

Lorsque le module 1 est alimenté en courant électrique, la portion 5d des conduits 5 joue le rôle d'évaporateur et leur portion 5c joue le rôle de condenseur, alors que dans l'échangeur 3, la portion 8c des conduits 8 joue le rôle d'évaporateur et leur portion 8d le rôle de condenseur.

En effet, au contact de la source froide, par l'intermédiaire de la surface d'échange thermique 6 et de la portion 5d des conduits 5, le liquide caloporteur contenu dans les conduits 5 s'évapore. Cette vapeur monte dans les conduits 5 jusqu'à leur portion 5c. Là, au contact de la face froide du module 1 par l'intermédiaire de la platine 4 et de la portion 5c des conduits 5, la vapeur se condense et, sous l'action de la force de pesanteur, redescend naturellement jusqu'à la portion 5d des conduits 5 dans leur branche 5b. On établit donc un transfert de chaleur naturel entre la source froide et le module thermoélectrique 1.

Simultanément et de manière symétrique, le liquide caloporteur contenu dans la portion 8c des conduits 8, au contact de la face chaude du module thermoélectrique 1, par l'intermédiaire de la platine 7 et de la portion 8c des conduits 8, s'évapore. Cette vapeur, lorsqu'elle arrive au contact de la source chaude par l'intermédiaire de la surface thermique d'échange 9 et de la portion 8d des conduits 8 se condense et, sous l'action de la force de pesanteur, le liquide résultant de cette condensation redescend jusqu'à la portion 8c des conduits 8 dans la partie inférieure de leur branche verticale 8a. Ainsi, on établit naturellement un transfert de chaleur depuis la face chaude du module thermoélectrique 1 jusqu'à la source chaude associée thermiquement avec la surface d'échange thermique 9.

Lorsque le courant d'alimentation du module thermoélectrique 1 est coupé, il se produit un transfert de chaleur entre la source chaude et la source froide très limité. En effet, la portion 5c des conduits 5 qui joue le rôle de condenseur ne peut pas jouer le rôle d'évaporateur étant donné qu'elle est remplie de vapeur. De même, en supposant que les branches verticales 8a des conduits 8 contiennent suffisamment de liquide pour au moins remplir leur portion 8c, ces portions qui jouent le rôle d'évaporateur ne peuvent se transformer en condenseur. Toutefois, si la portion 8c des conduits 8 n'est pas complètement remplie de liquide, il peut se produire une légère condensation dans ladite portion 8c.

Les conduits 5 de l'échangeur 2 constitue donc une barrière thermique agissant dans le sens allant de la face froide du module thermoélectrique 1 à la source froide, et les conduits 8 de l'échangeur 3 constituent une barrière thermique dans le sens allant de la source chaude à la face chaude du module thermoélectrique 1.

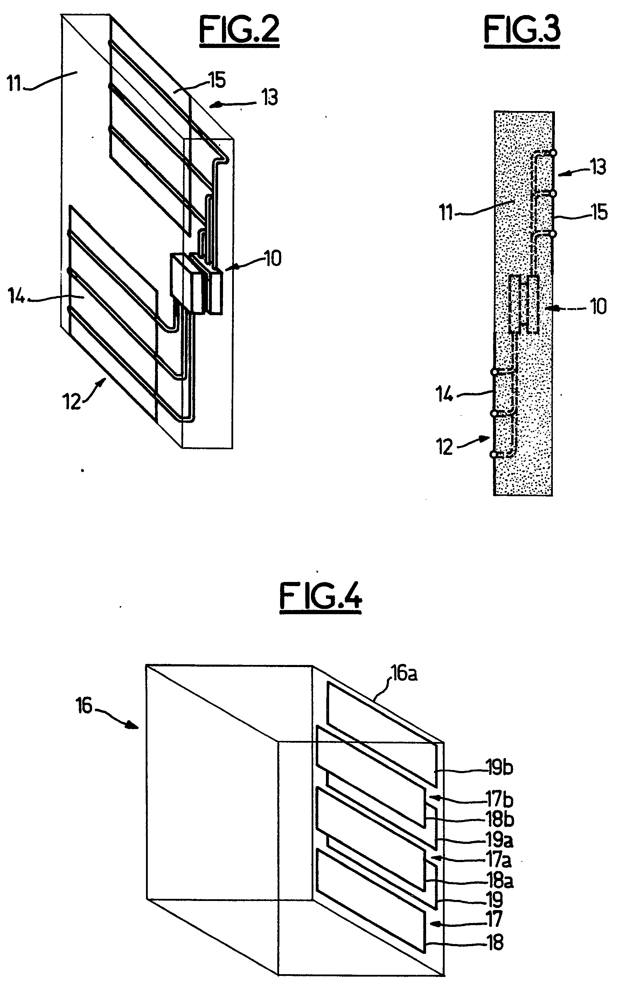

Les figures 2 et 3 représentent un panneau qui comprend un dispositif de transfert de chaleur dont la structure générale est semblable à celle du dispositif représenté sur la figure 1.

Dans l'exemple représenté sur les figures 2 et 3, le panneau se présente sous la forme d'un parallèlèlipède rectangle rempli par un isolant thermique 11.

Le dispositif de transfert de chaleur repéré d'une manière générale par la référence 10 est intégré dans l'isolant thermique 11. Il comprend un échangeur inférieur, repéré d'une manière générale par la référence 12 et un échangeur supérieur, repéré d'une manière générale par la référence 13 qui correspondent respectivement aux échangeurs 2 et 3 selon la figure 1.

Les surfaces d'échange thermique 14 et 15 des échangeurs 12 et 13, qui correspondent aux surfaces d'échange thermique 6 et 9 selon la figure 1, sont disposées de telle manière qu'elles forment en partie deux faces opposées verticales de ce panneau, la surface d'échange 14 couvrant en partie la partie inférieure d'une face verticale et la surface d'échange 15 couvrant en partie la partie supérieure de l'autre face. Lesdites surfaces d'échange 14 et 15 sont parallèles et à distance l'une de l'autre de manière à être séparées par l'isolant thermique 11.

Comme on peut le voir sur la figure 2, l'épaisseur de l'ensemble formé par les platines et le module thermoélectrique du dispositif 10 est inférieure à l'épaisseur du panneau dans le sens allant d'une surface d'échange thermique à l'autre. C'est pourquoi, les conduits des échangeurs 12 et 13 sont coudés au voisinage de la partie inférieure de leur branche verticale.

Un panneau tel qu'il est représenté sur les figures 2 et 3 peut donc constituer à lui seul une cloison de séparation entre une source chaude et une source froide, la source chaude étant du côté de la face du panneau comprenant la surface d'échange 15 et la source froide étant du côté du panneau comprenant la surface d'échange thermique 14. On peut, grâce au panneau représenté sur les figures 2 et 3 réaliser une cloison de séparation entre une source chaude et une source froide en superposant et assemblant plusieurs panneaux conformes aux figures 2 et 3 de telle sorte que leur surface d'échange 14 se trouve d'un même côté de la cloison, leur surface d'échange 15 se trouvant de l'autre côté.

Dans l'exemple représenté sur la figure 4, l'enceinte repérée d'une manière générale par la référence 16 et représentée schématiquement présente une paroi 16a comprenant des dispositifs de transfert de chaleur 17, 17a et 17b présentant chacun une structure générale semblable à celle du dispositif représenté sur la figure 1 et représentés très schématiquement.

Les dispositifs 17, 17a et 17b comprenent, respectivement des échangeurs inférieurs 18, 18a et 18b et respectivement des échangeurs supérieurs 19, 19a et 19b.

Les surfaces d'échange thermique associées aux échangeurs inférieurs 18, 18a et 18b forment en partie la face intérieure de la cloison 16a et les surfaces thermiques associées aux échangeurs supérieurs 19, 19a et 19b forment en partie la face extérieure opposée de la cloison 16a. Les surfaces 18, 18a et 18b et les surfaces 19, 19a et 19b sont à distance et séparées par un isolant thermique couvrant toute la cloison 16a.

Dans l'exemple représenté sur la figure 4, l'intérieur de l'enceinte 16 représente la source froide alors que l'extérieur de cette enceinte représente la source chaude. Le transfert de chaleur se fait de l'intérieur de l'enceinte 16 vers l'extérieur par la face 16a lorsque les modules thermoélectriques des dispositifs 17, 17a et 17b sont traversés par un courant électrique et l'inverse ne pouvant se produire par les dispositifs 17, 17a et 17b lorsque le courant électrique est coupé. L'enceinte 16 constitue donc un volume réfrigéré.

On remarquera toutefois que si les surfaces d'échange thermique des échangeurs supérieurs 19, 19a et 19b des dispositifs de transfert de chaleur 17, 17a et 17b sont placées sur la paroi intérieure de la cloison 16a et les surfaces d'échange thermique de leurs échangeurs inférieures 18, 18a et 18b placées sur la paroi extérieure de la cloison 16a, on obtient une enceinte réchauffée.

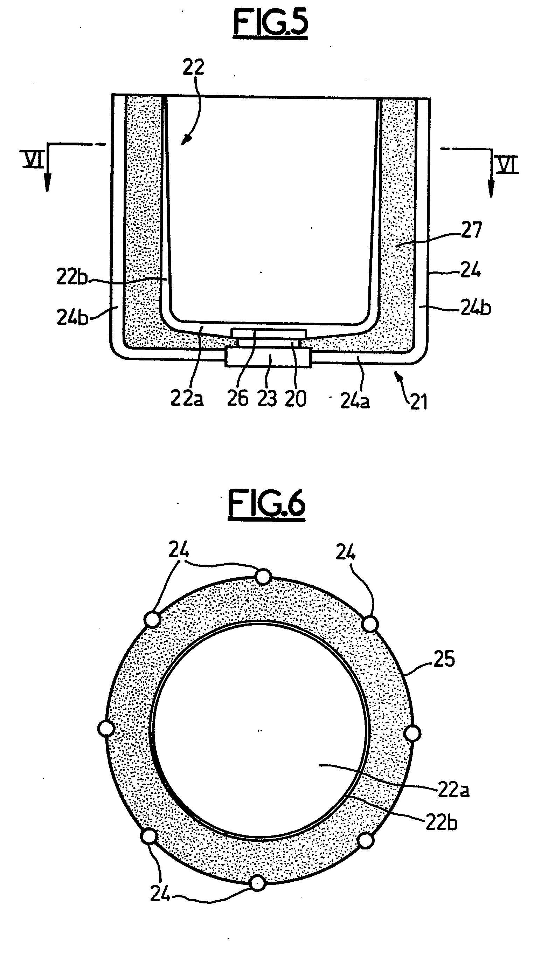

Les figures 5 et 6 sont relatives à un dispositif de transfert de chaleur dont la structure générale est différente de celle de la figure 1 mais dont le fonctionnement est semblable.

Le dispositif représenté sur les figures 5 et 6 comprend un module thermoélectrique 20 se présentant sous la forme d'une plaque disposée sensiblement horizontalement, ce module étant relié à une alimentation en courant non représentée. Lorsqu'il est traversé par un courant, le module thermoélectrique 20 présente une face inférieure chaude et une face supérieure froide.

Le dispositif comprend en outre un premier échangeur repéré d'une manière générale par la référence 21 et un second échangeur repéré d'une manière générale par la référence 22.

L'échangeur 21 comprend une platine rigide 23 associée thermiquement à la face chaude du module thermoélectrique 20, une multiplicité de conduits de transfert de chaleur 24 et une surface

0021307

d'échange thermique 25.

Les conduits 24 sont coudés de manière à présenter une branche horizontale 24a et une branche verticale 24b, leur branche 24b s'étendant vers le haut. Les branches horizontales 24a s'étendent radialement à partir de la platine 23 en formant entre elles des angles sensiblement égaux.

La partie d'extrémité des branches horizontales 24a des conduits 24, non visibles sur les figures, forme pour les conduits 24 une première portion qui est reliée thermiquement à la platine 23 en étant insérée dans celle-ci.

La partie supérieure des branches verticales 24b des conduits 24 forme pour les conduits 24 une seconde portion qui est reliée à la surface d'échange 25. La surface d'échange thermique 25 est sensiblement cylindrique et est reliée thermiquement à toutes les secondes portions des différents conduits 24, par exemple par soudage.

Les conduits 24 sont scellés à leurs extrémités et sont remplis d'un fluide qui se trouve à l'état de vapeur et de liquide, liquide qui se dispose dans les branches horizontales 24a.

L'échangeur de chaleur 22 comprend une platine 26 reliée thermiquement à la face froide du module thermoélectrique 20 et une surface d'échange thermique reliée thermiquement à la platine 26. La surface d'échange thermique 22 se présente sous la forme d'une cuvette ayant un fond sensiblement horizontal 22a fixé à la platine 26 et une paroi latérale 22b sensiblement cylindrique et s'étendant vers le haut. L'échangeur de chaleur 22 constitue donc un échangeur d'un type classique réalisé à l'aide d'une surface métallique mince bonne conductrice de chaleur.

Les platines 23 et 26 servent de support au module thermoélectrique 20 et servent également de support respectivement aux conduits 24 et à la surface d'échange thermique 22.

Comme on peut le voir sur les figures 5 et 6, la surface d'échange thermique 25 et la surface d'échange thermique 22b sont sensiblement concentriques et sont séparées par un isolant thermique 27 de manière à constituer un récipient cylindrique dont les faces intérieures sont formées par l'échangeur 22 et dont les faces extérieures sont formées par l'échangeur 21.

Lorsque le module thermoélectrique 20 est traversé par un courant électrique, le liquide qui se trouve dans les conduits 24 peut, par l'intermédiaire de la platine 23 et de la portion d'extrémité des branches horizontales 24a, s'évaporer à la température de la face chaude du module thermoélectrique 20. La vapeur qui se trouve dans la portion supérieure des branches verticales 24b des conduits 24 peut se condenser à la température de la source chaude reliée thermiquement à la surface d'échange thermique 25. Le fonctionnement de l'échangeur 21 est, dans l'autre sens, pratiquement impossible. En fait, l'échangeur 21 fonctionne de la même manière que l'échangeur supérieur 3 de la figure 1. L'échangeur 22 qui est constitué par une surface métallique permet de prendre de la chaleur à l'intérieur du récipient pour la transformer sur la face froide du module thermoélectrique 20 si bien que l'intérieur de l'échangeur 22 constitue une source froide.

Compte tenu de la structure et du fonctionnement de l'échangeur 21, les échanges de chaleur entre l'intérieur de l'enceinte et l'extérieur, lorsque le module thermoélectrique 20 n'est pas alimenté en courant électrique, sont très faibles si bien que l'on peut obtenir une enceinte réfrigérée.

On remarquera que dans l'exemple représenté sur les figures 5 et 6, il est impossible de prévoir pour l'échangeur 22, un échangeur comprenant des conduits de transfert de chaleur agencés d'une manière correspondante à celle de l'échangeur 21. En effet, la branche horizontale de ces conduits serait remplie de liquide, liquide qui serait en relation thermique avec la face froide du module. Il n'y aurait donc aucun transfert de chaleur entre l'intérieur du récipient et le module thermoélectrique 20.

Par ailleurs, si l'on veut obtenir un récipient chauffé, il suffit d'inverser la disposition des échangeurs 21 et 22 et également d'inverser le module thermoélectrique. Dans ce cas, l'échangeur intérieur muni de conduits fonctionnera de la même manière que l'échangeur 3 de la figure 1.

La présente invention ne se limite pas aux exemples de réalisation ci-dessus décrits. On peut en effet réaliser à partir du dispositif de transfert de chaleur conforme à la présente invention des enceintes climatiques chaudes ou froides, des barrières thermiques pour matériel ou personnes, de formes et de dimensions très variées, les conduits de transfert de chaleur et les surfaces d'échange thermique pouvant épouser toutes formes et avoir toutes dimensions tout en ne permettant un échange de chaleur que dans un seul sens.

On peut également utiliser le dispositif selon la présente invention pour le chauffage, le refroidissement ou la régulation très précise en température, par exemple de bains liquides ou d'appareils électroniques, ainsi que dans le domaine des capteurs solaires avec pompe à chaleur ou dans le domaine de la conversion de l'énergie solaire en énergie électrique.

D'une manière plus générale, le dispositif de la présente invention peut être appliqué chaque fois que l'on désire transférer de la chaleur dans un seul sens.

0021307

13

## REVENDICATIONS

1. Dispositif pour le transfert de chaleur entre au moins deux sources de chaleur de manière à les maintenir à des niveaux thermiques différents, comprenant au moins un module thermoélectrique à deux faces, générant une face froide et une face chaude lorsqu'il est traversé par un courant électrique et dont chaque face est reliée thermiquement à au moins un échangeur de chaleur présentant une grande surface d'échange thermique avec la source associée par rapport à celle du module thermoélectrique et utilisant un fluide de transfert de chaleur à deux états caractérisé par le fait qu'au moins l'échangeur relié à l'une des faces du module comprend une platine rigide servant de support audit module thermoélectrique et thermiquement associée à ladite face de ce module et au moins un conduit de transfert de chaleur scellé à ses extrémités et rempli par ledit fluide, ledit conduit de transfert de chaleur comprenant une première portion supportée par ladite platine est reliée thermiquement à ladite face du module par l'intermédiaire de ladite platine et une seconde portion reliée thermiquement à la source associée et séparée de ladite première portion, l'une desdites portions contenant du fluide à l'état de liquide alors que l'autre contient du fluide à l'état de vapeur si bien que l'échange de chaleur entre ladite face du module et la source associée ne se produit que dans un seul sens.

2. Dispositif selon la revendication 1 caractérisé par le fait que ladite première portion est disposée au-dessous de ladite seconde portion et contient le liquide, la première portion étant reliée thermiquement à la face chaude du module thermoélectrique par l'intermédiaire de ladite platine et jouant le rôle d'évaporateur et la seconde portion jouant le rôle de condenseur.

3. Dispositif selon la revendication 1 caractérisé par le fait que ladite première portion est disposée au-dessus de ladite seconde portion qui contient le liquide, la seconde portion jouant le rôle d'évaporateur et la première portion étant reliée thermiquement à la face froide du module thermoélectrique par l'intermédiaire de ladite platine et jouant le rôle de condenseur.

4. Dispositif selon l'une quelconque des revendications 1 à 3 caractérisé par le fait que ladite première portion est intégrée à la platine ou rapportée sur cette platine.

5. Dispositif selon l'une quelconque des revendications précédentes caractérisé par le fait qu'à ladite seconde portion du conduit de transfert de chaleur on associe au moins une surface d'échange thermique pour améliorer l'échange thermique entre le conduit et la source associée.

6. Dispositif selon l'une quelconque des revendications précédentes caractérisé par le fait qu'une surface d'échange thermique est reliée thermiquement à une platine servant de support audit module thermoélectrique et associée thermiquement à l'autre face de ce module.

7. Dispositif selon la revendication 1 caractérisé par le fait qu'il comprend une première platine associée thermiquement à la face froide dudit module et une seconde platine associée thermiquement à la face chaude dudit module, que lesdites platines servent de support audit module, qu'une multiplicité de conduits s'étendent vers le bas, ladite seconde portion desdits conduits étant associée à une surface d'échange, et qu'une multiplicité de conduits s'étendent vers le haut, ladite seconde portion de ces conduits étant associée thermiquement à une surface d'échange, lesdites premières portions desdites multiplicités de conduits étant reliées thermiquement auxdites platines respectivement.

8. Dispositif selon la revendication 8, caractérisé par le fait que lesdites surfaces d'échange sont sensiblement planes et parallèles et sont séparées par un isolant thermique de manière à réaliser un panneau.

9. Dispositif selon la revendication 1 caractérisé par le fait qu'une première platine est reliée thermiquement à une des faces dudit module et une seconde platine est reliée thermiquement à l'autre face dudit module, ces platines servant de support audit module, qu'une multiplicité de conduits dont la première portion est reliée thermiquement à une desdites platines s'étend à partir de cette platine de telle sorte que leur seconde portion soit associée à une surface d'échange thermique sensiblement cylindrique, que l'autre platine est reliée thermiquement à une surface d'échange thermique se présentant sou la forme d'une cuvette et que lesdites surfaces d'échange thermique sont emboîtées l'une dans l'autre et séparées par un isolant thermique de manière à constituer un récipient cylindrique.

10. Dispositif selon la revendication 10 caractérisé par le fait que la surface d'échange thermique reliée thermiquement à ladite multiplicité de conduits est disposée sur la face extérieure dudit cylindre, la seconde portion desdits conduits se trouvant au-dessus de leur première portion de telle sorte que l'intérieur du récipient forme alors une enceinte réfrigérée.

11. Dispositif selon la revendication 10 caractérisé par le fait que la surface d'échange thermique qui est reliée thermiquement à ladite multiplicité de conduits est disposée sur la face intérieure dudit cylindre, la seconde portion desdits conduits se trouvant au-dessus de leur première portion de telle sorte que l'intérieur du récipient forme une enceinte chauffée.

12. Dispositif selon l'une quelconque des revendications précédentes caractérisé par le fait que l'intérieur desdites portions dudit conduit de transfert de chaleur est tapissé d'une structure poreuse améliorant l'échange de chaleur entre la première portion et le module thermoélectrique et entre la seconde portion et la source associée.

FIG.1

## FIG.2

## FIG.3

## FIG.4

## FIG.5

## FIG.6

Office européen
des brevets

RAPPORT DE RECHERCHE EUROPEENNE

0021307

Numéro de la demande

EP 80 10 3350

| Catégorie | Citation du document avec indication, en cas de besoin, des parties pertinentes | Revendication concernée |
|---|---|---|
| | DE - B - 1 174 810 (SIEMENS) <br> * Revendication 1; figure 2 * <br> -- | 1-3 |
| | DE - B - 1 174 338 (SIEMENS) <br> * Revendication 1; figure 1 * <br> -- | 1-3,7 |
| | GB - A - 1 277 858 (CREMONESE) <br> * Revendication 1; figure 1 * <br> -- | 1,9,10 |
| | US - A - 4 011 104 (HUGHES AIR-CRAFT) <br> * Revendication 1; colonne 5, lignes 6-13 * <br> -- -- -- | 1,12 |

**DOCUMENTS CONSIDERES COMME PERTINENTS**

**CLASSEMENT DE LA DEMANDE (Int. Cl. 3)**

H 01 L 35/30

**DOMAINES TECHNIQUES RECHERCHES (Int. Cl. 3)**

H 01 L 35/30
35/22
F 25 B 21/02

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 26-09-1980 | DE RAEVE |

OEB Form 1503.1  06.78